(19) **Europäisches Patentamt**
**European Patent Office**
**Office européen des brevets**

(11) **EP 3 534 478 B1**

(12) **EUROPEAN PATENT SPECIFICATION**

(45) Date of publication and mention
of the grant of the patent:
**24.06.2026 Bulletin 2026/26**

(21) Application number: **18159231.2**

(22) Date of filing: **28.02.2018**

(51) International Patent Classification (IPC):
**H02J 3/00** *(2026.01)* **G01R 19/25** *(2006.01)*
**G01R 23/02** *(2006.01)* **G01R 25/00** *(2006.01)*
**H02J 13/12** *(2026.01)*

(52) Cooperative Patent Classification (CPC):
**H02J 3/00; G01R 19/2513; G01R 23/02;**
**G01R 25/00; H02J 13/12;** Y02E 60/00; Y04S 10/30

(54) **FREQUENCY AND PHASE ESTIMATION**

FREQUENZ- UND PHASENSCHÄTZUNG

ESTIMATION DE FRÉQUENCE ET DE PHASE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**04.09.2019 Bulletin 2019/36**

(73) Proprietor: **GE Vernova Technology GmbH**
**5400 Baden (CH)**

(72) Inventors:
• **BRIFF, Pablo Ariel**
**Stafford, Staffordshire ST16 1WS (GB)**
• **OMAR, Jasim Fadhel**
**Stafford, Staffordshire ST16 1WS (GB)**

(74) Representative: **Openshaw & Co.**
**8 Castle Street**
**Farnham, Surrey GU9 7HR (GB)**

(56) References cited:
**CN-A- 101 673 952     US-A1- 2013 051 498**

**Description**

FIELD OF THE INVENTION

The present disclosure relates to the field of alternating current (AC) power distribution, and in particular to systems and methods for estimating the grid frequency or grid phase angle of an AC power distribution system.

BACKGROUND

AC electrical power distribution systems are typically configured to operate at a particular grid frequency. The grid frequency is the nominal frequency of the alternating current in the electrical power distribution system, and is typically 50Hz or 60Hz. AC power distribution network operators endeavour to maintain the average grid frequency to within a specified tolerance of the nominal frequency.

Changes in the grid frequency can be indicative of changes in demand for electrical power, or can be indicative of faults in an electrical power distribution system. Similarly, changes in the grid phase angle of an electrical power distribution system can be indicative of changes in demand or faults in the system. Thus, there is considerable interest in techniques for monitoring and estimating grid frequency and grid phase angle in electrical power distribution systems.

Existing techniques for estimating grid frequency or phase involve positive sequence decomposition, a technique in which AC waveforms must be decomposed into positive and negative components before the grid frequency or phase can be estimated. These techniques tend to be slow and computationally complex, and may not provide accurate grid frequency or phase estimates, particularly during fault conditions.

Prior art examples are disclosed in US 2013/051498 A1 and CN 101 673 952 A. US 2013/051498 A1 discloses that three substantially simultaneous phase waveforms may be converted into a first quadrature signal and a zero sequence signal. For each phase waveform, a power system digital frequency may be determined through analysis of the first quadrature signal (e.g., and at least one additional prior quadrature signal) while eliminating waveform phase angles from the analysis. Subsequently, demodulation of the first quadrature signal and zero sequence signal based on the power system digital frequency results in a positive sequence phasor, a negative sequence phasor, and a zero sequence phasor. CN 101 673 952 A discloses a phase locking method based on a cross decoupling self-adaptive complex filter. Within the wording of claim 1 the document discloses estimating a grid frequency or grid phase angle of an electrical power distribution system, the method comprising:

- Sampling instantaneous voltages output by the electrical power distribution system at a plurality of discrete sample times to generate a plurality of samples;
- deriving $\alpha$ and $\beta$ values from the plurality of samples using a Clarke transformation;
- generating a complex variable from the derived $\alpha$ and $\beta$ values;
- based on the result of the integration generating an estimate of the grid frequency or grid phase angle.

A need therefore exists for an improved method for estimating the grid frequency or grid phase angle of an AC power distribution system.

SUMMARY

According to a first aspect, the invention provides a method for estimating a grid frequency or grid phase angle of an electrical power distribution system, the method comprising: sampling instantaneous voltages output by the electrical power distribution system at a plurality of discrete sample times to generate a plurality of samples; deriving $\alpha$ and $\beta$ values from the plurality of samples using a Clarke transformation; generating a complex variable from the derived $\alpha$ and $\beta$ values; applying the complex variable to a generating function; integrating the generating function for the plurality of samples; and based on the result of the integration of the generation function, generating an estimate of the grid frequency or grid phase angle.

The first aspect provides an improved method for estimating the grid frequency or grid phase angle which is less computationally complex than prior art methods, as it does not require positive sequence decomposition, and which produces more accurate estimates than prior art methods.

The generating function may have no singularities.

Integrating the generating function for the plurality of samples may comprise integrating the generation function until the integral of the generating function converges to a predefined value; and generating an estimate of the grid frequency or grid phase angle may comprise generating an estimate of the grid frequency based on the number of samples required for the integral of the generating function to converge to a predefined value.

The predefined value may approximate to a constant value. For example, the predefined value may approximate to zero.

The complex variable may be of the form $z = \alpha + j\beta$.

The generating function may be of the form $f(z) = exp(-(z(k) - z(k - 1))^2)$

Generating an estimate of the grid frequency or grid phase angle may comprise generating an estimate of the grid phase angle by adding the result of the integration of the generating function to a grid phase estimate for a previous cycle of the electrical power distribution system.

The complex variable may be of the form $z(k) = 1exp\left(j\,atan\frac{\beta(k)}{\alpha(k)}\right)$.

The generating function may be of the form $f(z) = z$.

A second aspect of the invention provides a system for estimating a grid frequency or grid phase angle of an electrical power distribution system, the system comprising: a sampler configured to sample instantaneous voltages output by the electrical power distribution system at a plurality of discrete sample times to generate a plurality of samples; a transformation unit configured to derive $\alpha$ and $\beta$ values from the plurality of samples using a Clarke transformation; a complex processing unit configured to generate a complex variable from the derived $\alpha$ and $\beta$ values and to apply the complex variable to a generating function; and an integrator unit configured to integrate the generating function for the plurality of samples and, based on the result of the integration of the generation function, generate an estimate of the grid frequency or grid phase angle.

The generating function may have no singularities.

The integrator unit may be configured to integrate the generating function for the plurality of samples until the integral of the generating function converges to a predefined value and to generate an estimate of the grid frequency based on the number of samples required for the integral of the generating function to converge to a predefined value.

The predefined value may approximate to a constant value. For example, the prefedined value may approximate to zero.

The complex variable may be of the form $z = \alpha + j\beta$.

The generating function may be of the form $f(z) = exp(-(z(k) - z(k - 1))^2)$

The integrator unit may be configured to generate an estimate of the grid phase angle by adding the result of the integration of the generating function to a grid phase estimate for a previous cycle of the electrical power distribution system.

In this case, the complex variable may be of the form $z(k) = 1exp\left(j\,atan\frac{\beta(k)}{\alpha(k)}\right)$.

The generating function may be of the form $f(z) = z$.

BRIEF DESCRIPTION OF THE DRAWINGS

Embodiments of the invention will now be described, strictly by way of example only, with reference to the accompanying drawings, of which:

Figure 1 is a flow diagram illustrating a method for estimating a grid frequency of an AC electrical distribution system;

Figure 2 illustrates complex plane trajectories of a complex function $z = \alpha + j\beta$;

Figure 3 is a schematic block diagram showing functional blocks in a system for performing the method of Figure 1;

Figure 4 is a flow diagram illustrating a method for estimating a grid phase angle of an AC electrical distribution system;

Figure 5 is a schematic block diagram showing functional blocks in a system for performing the method of Figure 4;

DETAILED DESCRIPTION

The present disclosure describes methods and systems for estimating the grid frequency and grid phase angle of an electrical distribution system with improved speed and accuracy as compared to prior art methods and systems.

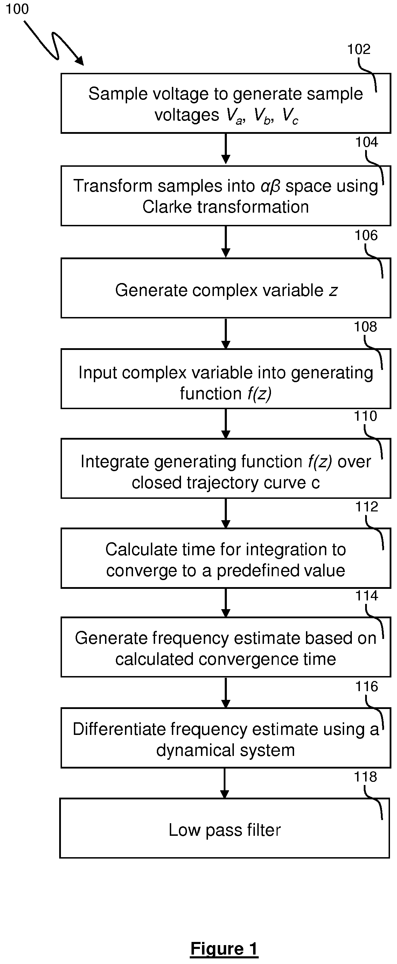

Referring first to Figure 1, a method for estimating the grid frequency of an electrical distribution system is shown generally at 100. The method 100 commences at step 102 by sampling the instantaneous voltage of three phases a, b and c of an AC electrical distribution system to generate samples $V_a$, $V_b$, $V_c$ representing the instantaneous voltages of the three phases at the point in time at which the samples were taken.

At step 104, a Clarke transformation is performed on the samples $V_a$, $V_b$, $V_c$, to transform the samples into the $\alpha\beta$ space. Thus the instantaneous voltages $V_a(k)$, $V_b(k)$, $V_c(k)$ at a time instant $k$ are transformed into values $\alpha(k)$ and $\beta(k)$.

At step 106, the $\alpha$ and $\beta$ values derived from the samples $V_a$, $V_b$, $V_c$ are used to generate a complex variable $z$, where $z = \alpha + j\beta$. Thus, the value $z(k)$ of the complex variable at the time instant k is defined by the instantaneous voltages $V_a(k)$, $V_b(k)$, $V_c(k)$ in the complex plane.

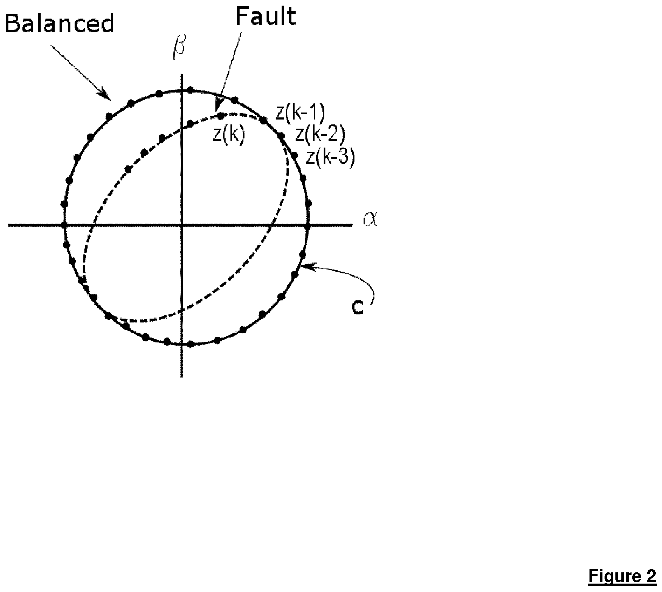

As shown in Figure 2, the complex variable z describes a closed trajectory curve c of N consecutive points in the complex domain, i.e. $c(k) = [z(k), z(k-1),..., z(k-N+1)]$, in steady state conditions, i.e. in conditions under which the trajectory remains settled for at least one cycle period of the AC electrical distribution system. This applies both under normal operating conditions and under fault conditions that last for at least one cycle period of the AC electrical distribution system, as shown in Figure 2.

At step 108, the generated complex variable $z$ is input to a generating function $f(z)$, and this generating function $f(z)$ is integrated over the closed trajectory curve c at step 110.

If the generating function $f(z)$ is chosen such that there are no singularities within the region delimited by the contour defined by the closed trajectory curve c in the z-plane (i.e. all of the values of $f(z)$ are finite), then using Cauchy's residue theorem it can be shown that the closed-loop integral of the generating function $f(z)$ along the curve $c$ is zero, i.e.:

$$\oint_c f(z)dz = 0 \qquad\qquad (1)$$

This property of the generating function $f(z)$ can be used to estimate the grid frequency of the electrical distribution system from which the samples $V_a$, $V_b$, $V_c$ were taken, since the curve c represents one cycle period of the sampled AC system, and so the time taken for the closed-loop integral of the generating function $f(z)$ along the curve c to converge to zero is the reciprocal of the grid frequency.

In a practical implementation, the closed-loop integral of the generating function $f(z)$ along the curve c can be approximated, e.g. by a digital signal processor or in software, by the summation:

$$\oint_c f(z)dz \approx \sum_{i=0}^{n-1} f(z(k-i))\Delta z(k-i) , \qquad\qquad (2)$$

where

$$\Delta z(k-i) \triangleq z(k-i) - z(k-i-1)$$

Any suitable generating function could be used. For example, the generating function could take the form $f(z) = exp(-(z(k) - z(k-1))^2)$. This exemplary generating function is useful for rejecting noise when $\Delta z(k)$ is affected by noisy measurements.

As will be appreciated, in practice the samples $V_a$, $V_b$, $V_c$ will be affected by noise and other factors, and so the integral defined in equation (1) above may not converge to exactly zero. Further, the approximation defined by the summation of equation (2) above may introduce additional error factors and may thus also not converge to exactly zero, but to a different constant value. Additionally, if the generating function $f(z)$ is chosen such that singularities are present within the region delimited by the contour defined by the closed trajectory curve c in the z-plane, then the integral of the generating function $f(z)$ along the curve c may converge to some other value, which may be a constant value.

To account for this, at step 112 a convergence time T, i.e. the time taken for the summation defined in equation (2) above to converge to a predefined value (which may be zero or a close approximation of zero, or may be some other predefined value, e.g. a constant value, selected to account for noise, errors and singularities), is calculated by multiplying the number n of samples required for the summation to equal the predefined value by the sample interval $T_s$, i.e.

$$T = nT_s \qquad\qquad (3)$$

The reciprocal of the calculated convergence time is then taken, at step 114, to generate an estimate $\hat{f}$ of the grid frequency.

It will be appreciated that the grid frequency estimate f can be updated every sample period, as the summation defined in equation (2) above can be performed every sample period, i.e. every $kT_s$ seconds.

As will be appreciated from the foregoing discussion, the grid frequency estimate f generated in step 114 will be susceptible to noise and sudden short lived changes arising, for example, from faults, and thus is not necessarily representative of the actual grid frequency over a longer period.

The grid frequency estimate $\hat{f}$ may therefore be refined in optional steps 116 and 118 by first differentiating the grid frequency estimate at step 116 using a dynamical system of the form $\dfrac{d\hat{\hat{f}}}{dt} = K(\hat{\hat{f}} - \hat{f})$ at step 116 (where $\hat{f}$ is the

frequency estimate generated at step 114 and f is the filtered frequency estimate), and then performing a low pass filtering (LPF) operation at step 118, thereby removing high frequency components of the grid frequency estimate that may be due to noise and short lived changes.

Using the method described above the grid frequency can be estimated quickly without needing to perform slow and computationally intensive decomposition of the AC waveforms into positive and negative waveforms. Further, experimental data shows that the method described above produces more accurate grid frequency estimates than prior art techniques.

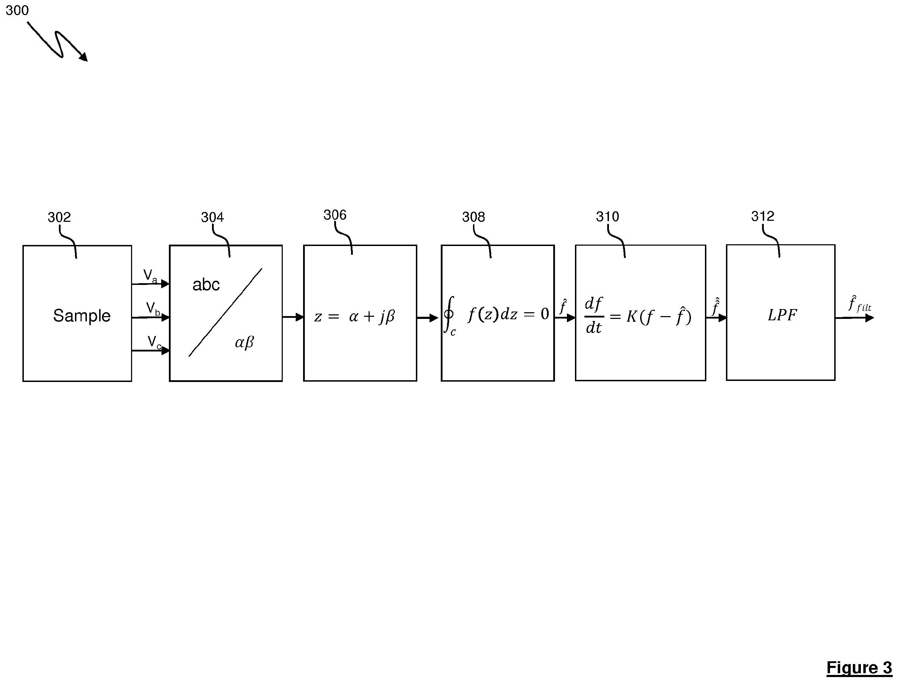

Turning now to Figure 3, a system for generating a grid frequency estimate is shown generally at 300. The system 300 may be implement in a variety of ways, for example as a plurality of separate electronic modules, in an appropriately programmed digital signal processor or as one or more software modules executing on a computer system.

The system 300 includes a sampler 302 configured to sample the instantaneous voltage of three phases a, b, c of an AC electrical distribution system to generate samples $V_a$, $V_b$, $V_c$ representing the instantaneous voltages of the three phases at the sample time k.

The sampler 302 outputs the samples $V_a$, $V_b$, $V_c$ to a transformation unit 304, which performs a Clarke transformation on the received samples $V_a$, $V_b$, $V_c$, to transform the samples into the $\alpha\beta$ space.

A complex processing unit 306 is then used to generate the complex variable $z = \alpha + \mathrm{j}\beta$ and to input the generated complex variable $z$ to the generating function $f(z)$. An integrator unit 308 is then used to integrate the generating function $f(z)$ over the closed trajectory curve c, as described above, and the time taken for the integration to converge to the predefined value is calculated by the integrator unit 308 by calculating the number of samples required for the integral to converge and multiplying this number by the sample interval, as described above. From the time taken for the integration to converge, the grid frequency estimate $\hat{f}$ is calculated by taking the reciprocal of the convergence time and output by the integrator unit 308.

Optionally, the grid frequency estimate $\hat{f}$ may be output by the integrator unit 308 to a differentiator unit 310, which is configured to differentiate the grid frequency estimate $\hat{f}$ using a dynamical system. The differentiator unit 310 outputs a differentiated version of the grid frequency estimate $\hat{f}$ to a low pass filter 312, which filters out high frequency components, thereby providing a refined version of the grid frequency estimate $\hat{f}$ as described above.

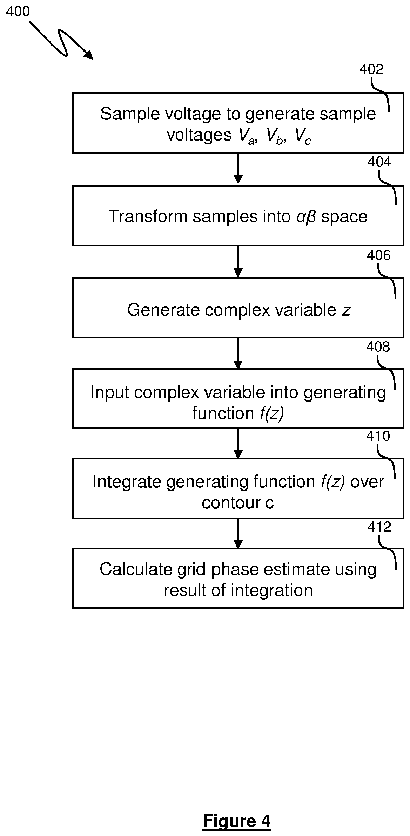

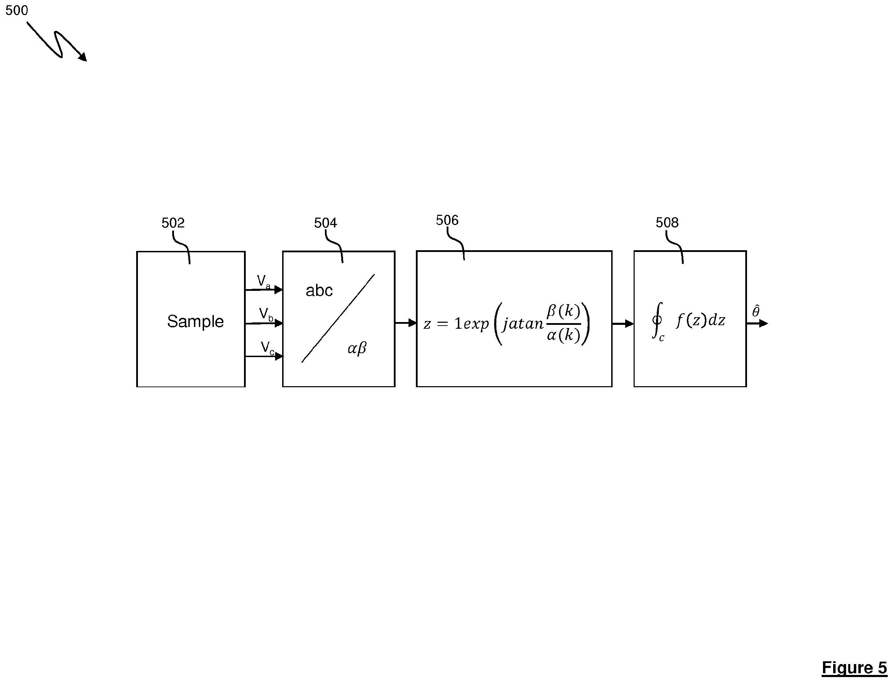

A similar technique can be used to estimate the grid phase angle, as will now be explained with reference to Figures 4 and 5.

Grid phase angle $\theta$ can be defined as:

$$\theta(t) = \int_0^t \omega t \, dt + \theta_0 \tag{4}$$

where $\theta_0$ is the initial phase angle.

The initial phase angle value $\theta_0$ can be obtained from the $\alpha$ and $\beta$ values derived from the Clarke transformation of the samples of the AC electrical distribution system as follows:

$$\theta_0 = atan\frac{\beta_0}{\alpha_0} \tag{5}$$

After one cycle of duration T, the phase angle resets to its initial value $\theta_0$, i.e.

$$\theta(T) = \int_0^T \omega dt + \theta_0 = \theta_0 + 2\pi \equiv \theta_0 \tag{6}$$

where $\omega = \frac{2\pi}{T}$

Thus, the integration over one complete cycle yields a difference in phase angle of $2\pi$ radians, which can be defined as zero change in phase. Hence:

$$\Delta\theta(T) \triangleq \theta(T) - \theta_0 = \int_0^T \omega dt \equiv 0 \tag{7}$$

Integrating equation (4) over one complete cycle gives:

$$\int_0^T \theta(t)dt = \int_0^{T/2} \theta(t)dt + \int_{T/2}^T \theta(t)dt \tag{8}$$

It can be assumed, without loss of generality, that $\theta_0 = 0$. Furthermore, in steady state

$$\theta(t) = \begin{cases} \omega t, \text{for } 0 \leq \omega t < \pi \\ -2\pi + \omega t, \text{for } \pi \leq \omega t < 2\pi \end{cases}$$

Then integral (8) becomes:

$$\int_0^T \theta(t)dt = \frac{1}{\omega}\int_0^{2\pi} \theta(\omega t)d(\omega t) = \frac{1}{\omega}\int_0^{\pi} \omega t \, d(\omega t) + \frac{1}{\omega}\int_{\pi}^{2\pi}(-2\pi + \omega t)d(\omega t) = 0 \quad (9)$$

where $\omega = \frac{2\pi}{T}$ .

A complex variable $z(k)$ can be defined as:

$$z(k) = 1 \exp\left(j \, atan \frac{\beta(k)}{\alpha(k)}\right) \qquad (10)$$

The value of $z(k)$ is chosen such that the method used to estimate the phase angle is sensitive only to changes in phase, and not to changes in the magnitude of the complex variable $z(k)$.

A generating function $f(z)$ can be chosen to minimise the effects of noisy measurements used to generate $\alpha(k)$ and $\beta(k)$. For example, the generating function $f(z)$ could take the form

$$f(z) = z \qquad (11)$$

A contour c can be defined as the following sequence of complex numbers:

$$c:\{z(k), z(k\text{-}1), \dots , z(k\text{-}N\text{+}1)\}$$

i.e., a unit circle with the samples spaced according to the phase estimates

$$\theta(k), \theta(k-1), \dots, \theta(k-N+1).$$

Then, integrating the generating function $f(z)$ over the contour c gives the error in the phase once one full cycle has been completed.

In a practical implementation, the closed-loop integral of the generating function $f(z)$ along the contour $c$ can be approximated, e.g. by a digital signal processor or in software, by the summation:

$$\oint_c f(z)dz \approx \sum_{i=0}^{n-1} \exp(j\theta(k-i))\Delta z(k-i) \qquad (12)$$

where n is the number of samples per period of the AC electrical distribution system.

In steady state conditions, $\Delta z(k-i) \approx \frac{2\pi}{n}$ , and so the summation (12) constitutes the summation of the complex magnitudes $z(k), z(k\text{-}1), \dots , z(k\text{-}N\text{+}1)$ which represent the grid phase angle.

An estimate $\hat{\theta}(k)$ of the grid phase angle at a sample time $k$ can be obtained using the equation

$$\hat{\theta}(k) = \hat{\theta}(k-n) + \oint_c f(z)dz$$

where the closed loop integration $\oint_c f(z)dz$ is approximated by equation (12) above. In the event that the phase angle has not changed, the closed loop integration $\oint_c f(z)dz$ equals zero, and so the phase angle estimate $\hat{\theta}(k)$ will be equal to the phase angle estimate at the corresponding point in the previous cycle, i.e. $\hat{\theta}(k) = \hat{\theta}(k\text{-}n)$. Any sudden changes in the phase can be detected quickly, since in the event of a change in the phase the closed loop integration $\oint_c f(z)dz$ would not equal zero and so the change in the phase angle would be immediately apparent in the phase angle estimate $\hat{\theta}(k)$.

Referring now to Figure 4, a method for estimating the grid phase angle of an electrical distribution system using the principles outlined above is shown generally at 400.

The method 400 commences at step 402 by sampling the instantaneous voltage of three phases a, b and c of an AC electrical distribution system to generate samples $V_a$, $V_b$, $V_c$ representing the instantaneous voltages of the three phases at the point in time at which the samples were taken.

At step 404, a Clarke transformation is performed on the samples $V_a$, $V_b$, $V_c$, to transform the samples into the $\alpha\beta$ space. Thus the instantaneous voltages $V_a(k)$, $V_b(k)$, $V_c(k)$ at time instant $k$ are transformed into values $\alpha(k)$ and $\beta(k)$.

At step 406, a complex variable $z$ is generated using the values $\alpha(k)$ and $\beta(k)$. As discussed above, the complex variable $z$ may take the form $z(k) = 1 exp\left(j\, atan\frac{\beta(k)}{\alpha(k)}\right)$.

At step 408, the complex variable $z$ is input into a generating function $f(z)$. As discussed above, the generating function $f(z)$ can take the form $f(z) = z$, or can take any other convenient form.

At step 410, the generating function $f(z)$ is integrated over the contour c defined above, and the result of this integration is added, at step 412, to a grid phase estimate $\hat{\theta}(k - n)$ for a corresponding point in a previous cycle of the electrical distribution system to generate a grid phase estimate $\hat{\theta}$. If there has been no change in the phase, the grid phase estimate $\hat{\theta}$ will be equal to the grid phase estimate $\hat{\theta}(k - n)$, since the integral over the contour c will be equal to zero. If on the other hand the phase has changed, then the grid phase estimate $\hat{\theta}$ will be different from the grid phase estimate $\hat{\theta}(k - n)$. Because a new grid phase estimate $\hat{\theta}$ can be generated at each sample point k, any changes in the grid phase can rapidly be detected.

Using the method described above the grid phase can be estimated quickly without needing to perform slow and computationally intensive decomposition of the AC waveforms into positive and negative waveforms.

Turning now to Figure 5, a system for generating a grid phase estimate is shown generally at 500. The system 500 may be implemented in a variety of ways, for example as a plurality of separate electronic modules, in an appropriately programmed digital signal processor or as one or more software modules executing on a computer system.

The system 500 includes a sampler 502 configured to sample the instantaneous voltage of three phases a, b, c of an AC electrical distribution system to generate samples $V_a$, $V_b$, $V_c$ representing the instantaneous voltages of the three phases at the sample time $k$.

The sampler 502 outputs the samples $V_a$, $V_b$, $V_c$ to a transformation unit 504, which performs a Clarke transformation on the received samples $V_a$, $V_b$, $V_c$, to transform the samples into the $\alpha\beta$ space.

A complex processing unit 506 is then used to generate the complex variable z and to input the generated complex variable $z$ to the generating function $f(z)$. An integrator unit 508 is then used to integrate the generating function $f(z)$ over the contour c, as described above, and the result of this integration is added by the integrator unit 508 to a grid phase estimate $\hat{\theta}(k - n)$ for a corresponding point in a previous cycle of the electrical distribution system to generate a grid phase estimate $\hat{\theta}$ which is output by the integrator unit 508.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality. Any reference signs in the claims shall not be construed so as to limit their scope.

**Claims**

1. A method for estimating a grid frequency or grid phase angle of an electrical power distribution system, the method comprising:

   Sampling (102, 402) instantaneous voltages output by the electrical power distribution system at a plurality of discrete sample times to generate a plurality of samples;
   deriving (104, 404) $\alpha$ and $\beta$ values from the plurality of samples using a Clarke transformation;
   generating (106, 406) a complex variable from the derived $\alpha$ and $\beta$ values;
   applying (108, 408) the complex variable to a generating function;
   integrating (110, 410) the generating function for the plurality of samples; and
   based on the result of the integration of the generation function, generating an estimate of the grid frequency (114) or grid phase angle (412).

2. A method according to claim 1 wherein the generating function has no singularities.

3. A method according to claim 1 or claim 2 wherein integrating the generating function for the plurality of samples comprises integrating the generation function until the integral of the generating function converges to a predefined value; and wherein generating an estimate of the grid frequency or grid phase angle comprises generating an estimate of the grid frequency based on the number of samples required for the integral of the generating function to converge to a predefined value.

4. A method according to claim 3 wherein the predefined value approximates to a constant value.

5. A method according to any one of claims 2 to 4 wherein the complex variable is of the form $z = \alpha + j\beta$.

6. A method according to any one of claims 3 to 5 wherein the generating function is of the form $f(z) = exp(-(z(k) - z(k-1))^2)$.

7. A method according to claim 1 or claim 2 wherein generating an estimate of the grid frequency or grid phase angle comprises generating an estimate of the grid phase angle by adding the result of the integration of the generating function to a grid phase estimate for a previous cycle of the electrical power distribution system.

8. A method according to claim 7 wherein the complex variable is of the form $z(k) = 1 exp\left(j\ atan\frac{\beta(k)}{\alpha(k)}\right)$ .

9. A method according to claim 7 or claim 8 wherein the generating function is of the form $f(z) = z$.

10. A system for estimating a grid frequency or grid phase angle of an electrical power distribution system, the system comprising:

a sampler (302, 502) configured to sample instantaneous voltages output by the electrical power distribution system at a plurality of discrete sample times to generate a plurality of samples;
a transformation unit (304, 504) configured to derive $\alpha$ and $\beta$ values from the plurality of samples using a Clarke transformation;
a complex processing unit (306, 506) configured to generate a complex variable from the derived $\alpha$ and $\beta$ values and to apply the complex variable to a generating function;
an integrator unit (308, 508) configured to integrate the generating function for the plurality of samples and, based on the result of the integration of the generation function, generate an estimate of the grid frequency or grid phase angle.

11. A system according to claim 10 wherein the generating function has no singularities.

12. A system according to claim 10 or claim 11 wherein the integrator unit is configured to integrate the generating function for the plurality of samples until the integral of the generating function converges to a predefined value and to generate an estimate of the grid frequency based on the number of samples required for the integral of the generating function to converge to a predefined value.

13. A system according to claim 12 wherein the complex variable is of the form $z = \alpha + j\beta$ and wherein the generating function is of the form $f(z) = exp(-(z(k) - z(k-1))^2)$.

14. A system according to claim 12 wherein the integrator unit is configured to generate an estimate of the grid phase angle by adding the result of the integration of the generating function to a grid phase estimate for a previous cycle of the electrical power distribution system.

15. A system according to claim 14 wherein the complex variable is of the form $z(k) = 1 exp\left(j\ atan\frac{\beta(k)}{\alpha(k)}\right)$ and wherein the generating function is of the form $f(z) = z$.

## Patentansprüche

1. Verfahren zum Schätzen einer Netzfrequenz oder eines Netzphasenwinkels eines elektrischen Energieverteilungssystems, wobei das Verfahren umfasst:

Abtasten (102, 402) der von dem elektrischen Energieverteilungssystem ausgegebenen Momentanspannungen zu einer Vielzahl von diskreten Abtastzeitpunkten, um eine Vielzahl von Abtastwerten zu erzeugen;

Ableiten (104, 404) von $\alpha$- und $\beta$-Werten aus der Vielzahl von Abtastwerten unter Verwendung einer Clarke-Transformation;

Erzeugen (106, 406) einer komplexen Variablen aus den $\alpha$- und $\beta$-Werten;

Anwenden (108, 408) der komplexen Variablen auf eine erzeugende Funktion;

Integrieren (110, 410) der erzeugenden Funktion für die Vielzahl von Abtastwerten; und

basierend auf dem Ergebnis der Integration der Erzeugungsfunktion, Erzeugen einer Schätzung der Netzfrequenz (114) oder des Netzphasenwinkels (412).

2. Verfahren nach Anspruch 1, wobei die erzeugende Funktion keine Singularitäten aufweist.

3. Verfahren nach Anspruch 1 oder Anspruch 2, wobei Integrieren der erzeugenden Funktion für die Vielzahl von Abtastwerten Integrieren der Erzeugungsfunktion umfasst, bis das Integral der erzeugenden Funktion gegen einen vordefinierten Wert konvergiert; und wobei Erzeugen einer Schätzung der Netzfrequenz oder des Netzphasenwinkels Erzeugen einer Schätzung der Netzfrequenz basierend auf der Anzahl von Abtastwerten umfasst, welche erforderlich sind, damit das Integral der erzeugenden Funktion gegen einen vordefinierten Wert konvergiert.

4. Verfahren nach Anspruch 3, wobei der vordefinierte Wert sich einem konstanten Wert annähert.

5. Verfahren nach einem der Ansprüche 2 bis 4, wobei die komplexe Variable die Form $z = \alpha + j\beta$ hat.

6. Verfahren nach einem der Ansprüche 3 bis 5, wobei die erzeugende Funktion die Form $f(z) = exp\,(-(z(k) - z(k-1))^2)$ hat.

7. Verfahren nach Anspruch 1 oder Anspruch 2, wobei Erzeugen einer Schätzung der Netzfrequenz oder des Netzphasenwinkels Erzeugen einer Schätzung des Netzphasenwinkels durch Addieren des Ergebnisses der Integration der erzeugende Funktion zu einer Netzphasenschätzung für einen vorherigen Zyklus des elektrischen Energieverteilungssystems umfasst.

8. Verfahren nach Anspruch 7, wobei die komplexe Variable die Form $z(k) = 1 exp\left(j\,atan\frac{\beta(k)}{\alpha(k)}\right) hat.$

9. Verfahren nach Anspruch 7 oder Anspruch 8, wobei die erzeugende Funktion die Form $f(z) = z$ hat.

10. System zum Schätzen einer Netzfrequenz oder eines Netzphasenwinkels eines elektrischen Energieverteilungssystems, wobei das System umfasst:

einen Abtaster (302, 502), welcher dazu konfiguriert ist, die von dem elektrischen Energieverteilungssystem ausgegebenen Momentanspannungen zu einer Vielzahl von diskreter Abtastzeitpunkte abzutasten, um eine Vielzahl von Abtastwerten zu erzeugen;

eine Transformationseinheit (304, 504), welche dazu konfiguriert ist, $a$- und $\beta$-Werte aus der Vielzahl der Abtastwerte unter Verwendung einer Clarke-Transformation abzuleiten;

eine komplexe Verarbeitungseinheit (306, 506), welche dazu konfiguriert ist, aus den abgeleiteten $a$- und $\beta$-Werten eine komplexe Variable zu erzeugen und diese komplexe Variable auf eine erzeugende Funktion anzuwenden;

eine Integratoreinheit (308, 508), welche dazu konfiguriert ist, die erzeugende Funktion für die Vielzahl von Abtastwerten zu integrieren, und basierend auf dem Ergebnis der Integration der Erzeugungsfunktion, eine Schätzung der Netzfrequenz oder des Netzphasenwinkels zu erzeugen.

11. System nach Anspruch 10, wobei die erzeugende Funktion keine Singularitäten aufweist.

12. System nach Anspruch 10 oder Anspruch 11, wobei die Integratoreinheit dazu konfiguriert ist, die erzeugende Funktion für die Vielzahl von Abtastwerten zu integrieren bis das Integral der erzeugenden Funktion gegen einen vordefinierten Wert konvergiert, und eine Schätzung der Netzfrequenz basierend auf der Anzahl von Abtastwerten zu erzeugen, welche erforderlich sind, damit das Integral der erzeugenden Funktion gegen einen vordefinierten Wert konvergiert.

13. System nach Anspruch 12, wobei die komplexe Variable die Form $z = \alpha + j\beta$ hat und wobei die erzeugende Funktion die Form $f(z) = exp\,(-(z(k) - z(k-1))^2)$ hat.

**14.** System nach Anspruch 12, wobei die Integratoreinheit dazu konfiguriert ist, eine Schätzung des Netzphasenwinkels durch Addieren des Ergebnisses der Integration der erzeugende Funktion zu einer Netzphasenschätzung für einen vorherigen Zyklus des elektrischen Energieverteilungssystems zu erzeugen.

**15.** System nach Anspruch 14, wobei die komplexe Variable die Form $z(k) = 1 exp \left( j\, atan \frac{\beta(k)}{\alpha(k)} \right)$ hat und wobei die erzeugende Funktion die Form *f(z) = z* hat.

## Revendications

**1.** Procédé d'estimation d'une fréquence de réseau ou d'un angle de phase de réseau d'un système de distribution d'énergie électrique, le procédé comprenant :

l'échantillonnage (102, 402) de tensions instantanées produites par le système de distribution d'énergie électrique à une pluralité de temps d'échantillonnage discrets pour générer une pluralité d'échantillons ;
la déduction (104, 404) de valeurs $\alpha$ et $\beta$ de la pluralité d'échantillons à l'aide d'une transformation de Clarke ;
la génération (106, 406) d'une variable complexe à partir des valeurs $\alpha$ et $\beta$ ;
l'application (108, 408) de la variable complexe à une fonction génératrice ;
l'intégration (110,410) de la fonction génératrice pour la pluralité d'échantillons ; et
sur la base du résultat de l'intégration de la fonction génératrice, la génération d'une estimation de la fréquence de réseau (114) ou de l'angle de phase de réseau (412).

**2.** Procédé selon la revendication 1 dans lequel la fonction génératrice ne présente aucune singularité.

**3.** Procédé selon la revendication 1 ou 2, dans lequel l'intégration de la fonction génératrice pour la pluralité d'échantillons comprend l'intégration de la fonction génératrice jusqu'à ce que l'intégrale de la fonction génératrice converge vers une valeur prédéfinie ; et dans lequel la génération d'une estimation de la fréquence de réseau ou de l'angle de phase de réseau comprend la génération d'une estimation de la fréquence de réseau sur la base du nombre d'échantillons requis pour que l'intégrale de la fonction génératrice converge vers une valeur prédéfinie.

**4.** Procédé selon la revendication 3, dans lequel la valeur prédéfinie se rapproche d'une valeur constante.

**5.** Procédé selon l'une quelconque des revendications 2 à 4, dans lequel la variable complexe est sous la forme de $z = \alpha + j\beta$.

**6.** Procédé selon l'une quelconque des revendications 3 à 5, dans lequel la fonction génératrice est sous la forme de *f(z) = exp (-(z(k) - z(k - 1))²)*.

**7.** Procédé selon la revendication 1 ou la revendication 2, dans lequel la génération d'une estimation de la fréquence de réseau ou de l'angle de phase de réseau comprend la génération d'une estimation de l'angle de phase de réseau en ajoutant le résultat de l'intégration de la fonction génératrice à une estimation de phase de réseau pour un cycle précédent du système de distribution d'énergie électrique.

**8.** Procédé selon la revendication 7, dans lequel la variable complexe est sous la forme de $z(k) = 1 exp \left( j\, atan \frac{\beta(k)}{\alpha(k)} \right).$

**9.** Procédé selon la revendication 7 ou la revendication 8, dans lequel la fonction génératrice est sous la forme de *f(z) = z*.

**10.** Système d'estimation d'une fréquence de réseau ou d'un angle de phase de réseau d'un système de distribution d'énergie électrique, le système comprenant :

un échantillonneur (302, 502) configuré pour échantillonner des tensions instantanées produites par le système de distribution d'énergie électrique à une pluralité de temps d'échantillonnage discrets pour générer une pluralité d'échantillons ;
une unité de transformation (304, 504) configurée pour déduire des valeurs *a* et $\beta$ à partir de la pluralité d'échantillons à l'aide d'une transformation de Clarke ;

une unité de traitement complexe (306, 506) configurée pour générer une variable complexe à partir des valeurs $a$ et $\beta$ déduites et pour appliquer la variable complexe à une fonction génératrice ;

une unité d'intégration (308, 508) configurée pour intégrer la fonction génératrice pour la pluralité d'échantillons et, sur la base du résultat de l'intégration de la fonction génératrice, générer une estimation de la fréquence de réseau ou de l'angle de phase de réseau.

11. Système selon la revendication 10, dans lequel la fonction génératrice ne présente aucune singularité.

12. Système selon la revendication 10 ou la revendication 11, dans lequel l'unité d'intégration est configurée pour intégrer la fonction génératrice pour la pluralité d'échantillons jusqu'à ce que l'intégrale de la fonction génératrice converge vers une valeur prédéfinie et pour générer une estimation de la fréquence de réseau sur la base du nombre d'échantillons requis pour que l'intégrale de la fonction génératrice converge vers une valeur prédéfinie.

13. Système selon la revendication 12, dans lequel la variable complexe est sous la forme de $z = \alpha + \mathrm{j}\beta$ et dans lequel la fonction génératrice est sous la forme de $f(z) = \exp(-(z(k) - z(k-1))^2)$.

14. Système selon la revendication 12, dans lequel l'unité d'intégration est configurée pour générer une estimation de l'angle de phase de réseau en ajoutant le résultat de l'intégration de la fonction génératrice à une estimation de phase de réseau pour un cycle précédent du système de distribution d'énergie électrique.

15. Système selon la revendication 14, dans lequel la variable complexe est sous la forme de $z(k) = 1 exp\left(j atan\frac{\beta(k)}{\alpha(k)}\right)$ et dans lequel la fonction génératrice est sous la forme de $f(z) = z$.

100

102

Sample voltage to generate sample voltages $V_a$, $V_b$, $V_c$

104

Transform samples into $\alpha\beta$ space using Clarke transformation

106

Generate complex variable $z$

108

Input complex variable into generating function $f(z)$

110

Integrate generating function $f(z)$ over closed trajectory curve c

112

Calculate time for integration to converge to a predefined value

114

Generate frequency estimate based on calculated convergence time

116

Differentiate frequency estimate using a dynamical system

118

Low pass filter

**Figure 1**

**Figure 2**

**Figure 3**

400

402

Sample voltage to generate sample voltages $V_a$, $V_b$, $V_c$

404

Transform samples into $\alpha\beta$ space

406

Generate complex variable $z$

408

Input complex variable into generating function $f(z)$

410

Integrate generating function $f(z)$ over contour c

412

Calculate grid phase estimate using result of integration

**Figure 4**

500

| | | | |
|---|---|---|---|
| Sample | abc / $\alpha\beta$ | $z = 1\exp\left(j\tan\dfrac{\beta(k)}{\alpha(k)}\right)$ | $\displaystyle\oint_c f(z)\,dz$ |

502

504

506

508

$V_a$  $V_b$  $V_c$

$\hat{\theta}$

**Figure 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013051498 A1

- CN 101673952 A